# EUROPEAN PATENT APPLICATION

(11) **EP 2 584 384 A1**
(43) Date of publication of application: **24.04.2013**
(21) Application number: 11795585.6
(22) Date of filing: 06.06.2011
(51) Int. Cl.: G02B 5/08, F24J 2/10, H01L 31/052

(54) **FILM MIRROR FOR REFLECTING SUNLIGHT AND REFLECTIVE DEVICE FOR SOLAR THERMAL POWER GENERATION**

(30) Priority: 15.06.2010 JP 2010135938
(71) Applicant: Konica Minolta Advanced Layers, Inc., Hachioji-shi Tokyo 192-8505 (JP)
(72) Inventor: HONDA, Mika, Hachioji-shi Tokyo 192-8505 (JP)
(74) Representative: Gille Hrabal
(86) International application number: PCT/JP2011/062882
(87) International publication number: WO 2011/158677

(57) **Abstract**

Disclosed is a film mirror for reflecting sunlight, which comprises, sequentially from the sunlight incident side, a polymer film base, a reflective layer that is configured of a silver coating, and a protective coating layer. The film mirror for reflecting sunlight is characterized in that the reflective layer is formed by applying and firing a coating liquid that contains a silver complex compound.

## Description

### Technical Field

The present invention relates to a film mirror for reflecting sunlight including a reflective layer provided with silver coating, and a reflective device for solar thermal power generation including the film mirror.

### Background Art

Global warming in recent years has developed into such a serious situation as to threaten even the survival of mankind in the future. The main cause of global warming has been believed to be atmospheric carbon dioxide (CO₂) emitted from fossil fuels which have been used in large amounts as energy sources in the 20th century. Accordingly, in the near future, we may no longer be allowed to continue use of fossil fuels at the current rate. At the same time, depletion of natural gas and oil, which was believed to be inexhaustible in the past, seems to become more likely due to increasing energy demand accompanied by the rapid economic growth of so-called developing countries, e.g., China, India, and Brazil.

Examples of the currently studied alternative energies for fossil fuel energies such as oil and natural gas energies include coal, biomass, and nuclear energies, and natural energies such as wind and solar energies. Among these alternative energies, solar energy is believed to be the most stable and abundant natural energy.

Although solar energy is a significantly promising alternative energy, it has disadvantages of (1) low energy density and (2) difficulties in storage and transport from the viewpoint of its utilization.

In order to overcome the disadvantage of its low energy density, collecting solar energy with a huge reflective device has been proposed.

Glass mirrors have been used for reflective devices exposed to severe environmental conditions such as ultraviolet light and heat from the sun, wind and rain, and sandstorm. Although glass mirrors are highly durable for various environments, they have disadvantages such as damage during transport and significantly high weights in large sizes, leading to high plant construction costs for providing necessary strength of mounts on which the mirrors are installed. Furthermore, glass mirrors are so fragile that workers should concern about avoiding injury by fragments when replacing them. Moreover, glass mirrors are often installed indoors and are affected by working environments (e.g., wind, rain, sand and dust) ; hence, the workers must have mature techniques to replace them.

To solve such problems, a method of replacing a glass mirror with a reflective resin sheet is disclosed in Japanese Unexamined Patent Application Publication No. 2005-59382.

In the case where a resin film is used as a film mirror for reflecting sunlight for solar thermal power generation (hereafter also referred to as a "sunlight reflective film mirror", "film mirror" or simply "mirror"), however, problems such as degradation of the overall reflectance and regular reflectance due to various factors become more evident compared to glass mirrors.

For example, in a process of forming a reflective layer on one side of a resin film by a silver plating method, a silver plating layer may also be formed on the other side of the film in some cases. Removal of the layer on the other side with, for example, nitric acid causes deterioration of the resin film. Furthermore, the adherence between the reflective layer formed by the plating method and the resin film is not satisfactory.

Meanwhile, a process of making a reflective film mirror is known. The process involves forming a primer layer on a resin film; forming a copper plating layer thereon, and forming a silver plating layer by displacement plating which utilizes a difference in ionization tendency. This process, however, uses an environmentally harmful copper compound. Furthermore, the rate of the displacement plating cannot be readily controlled. This precludes formation of an even or flat silver plating layer essential for high regular reflectance.

A reflective film having an undercoat layer, a metal reflective layer, a primer layer, a weather resistant resin layer formed over a plastic film is disclosed (see Patent Document 1). This method involves forming a metal reflective layer by vapor deposition on a non-uniform surface of a primer layer formed by a coating process. The interface between the metal reflective layer (light reflecting surface) and the primer layer cannot be smooth enough to provide a desired regular reflectance. Vapor deposition, which has been also studied for forming a reflective layer, requires large-scale special equipment such as a vacuum chamber for the vapor deposition, which imposes a great load on manufacturing facilities.

To overcome such a problem, a method of forming a primer layer on a substrate, a reflective layer by a wet process with a liquid composition containing an organic silver complex compound for a reflective film, and optionally a post-coat layer and a transparent overcoat layer in this order is disclosed (see Patent Document 2). The method of forming a reflective layer by a wet coating process does not require large-size special equipment essential for vapor deposition and thus exhibit high productivity, but it cannot provide a high regular reflectance since the reflective layer (i.e., light reflecting surface) formed by wet coating has an uneven surface affected by the surface profile of the primer layer. Furthermore, the reflective layer according to the method has a problem of durability i.e., deterioration of the transparent overcoat layer, which is directly exposed to sunlight and air. Accordingly, it has been desired to develop a film mirror for reflecting sunlight which can be manufactured with simple production equipment and has a high regular reflectance, excellent weather resistance, and high abrasion resistance.

### Prior Art Documents

### Patent Documents

Patent document 1: Japanese Unexamined Patent Application Publication No. 2005-280131
Patent document 2: Japanese Unexamined Patent Application Publication No. 2009-535661

### Summary of the Invention

### Problem to be Solved by the Invention

An object of the present invention to solve such a problem is to provide a film mirror for reflecting sunlight which can be manufactured with simple production equipment and has a high regular reflectance, excellent weather resistance, high abrasion resistance and strong adherence, and to provide a reflective device for solar thermal power generation including the film mirror.

### Means to Solve the Problem

An object of the invention is achieved by the following configurations.

(Item 1) A film mirror for reflecting sunlight includes, in sequence from the incident side of sunlight, a polymer film substrate, a reflective layer including silver coating, and a protective coating layer. The reflective layer is formed by coating and calcining (firing) a coating liquid containing a silver complex compound.

(Item 2) The film mirror for reflecting sunlight according to item 1 further includes a primer layer between the polymer film substrate and the reflective layer.

(Item 3) The silver complex compound of the film mirror for reflecting sunlight according to item 1 or 2 is prepared by a reaction of a silver compound represented by Formula (1) with at least one compound selected from the compounds represented by Formulae (2) to (4).

Formula (1) AgₙX

where X represents at least one substituent selected from the group consisting of an oxygen atom, a sulfur atom, a halogen atom, a cyano group, a cyanate group, a carbonate group, a nitrate group, a nitrite group, a sulfate group, a phosphate group, a thiocyanate group, a chlorate group, a perchlorate group, a tetrafluoroborate group, an acetylacetonate group, a carboxylate group and derivatives thereof, and n represents an integer of 1 to 4.

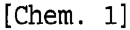

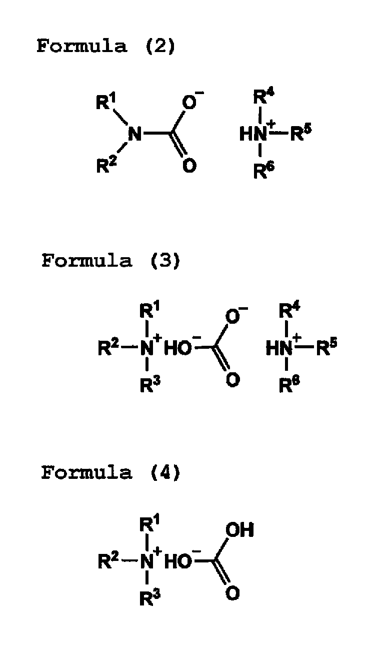

where R¹ to R⁶ each independently represent at least one substituent selected from the group consisting of a hydrogen atom, an aliphatic alkyl group having 1 to 30 carbon atoms, an alicyclic alkyl group having 1 to 30 carbon atoms, an aryl group, an aralkyl group, a functional-group-substituted alkyl group, a functional-group-substituted aryl group, a heterocyclic group, a polymer group, and derivatives thereof.

(Item 4) The polymer film substrate of the film mirror for reflecting sunlight according to any one of items 1 to 3 has a thickness of 9 µm or more and 175 µm or less.

(Item 5) The polymer film substrate of the film mirror for reflecting sunlight according to any one of items 1 to 4 includes an acrylic resin film or a polyolefin resin film.

(Item 6) The polymer film substrate of the film mirror for reflecting sunlight according to any one of items 1 to 5 includes a UV absorber.

(Item 7) The polymer film substrate of the film mirror for reflecting sunlight according to any one of items 1 to 6 includes an antioxidant or stabilizer.

(Item 8) A reflective device for solar thermal power generation includes the film mirror for reflecting sunlight according to any one of the items 1 to 7 provided on a holding member through an adhesive layer.

### Effects of the Invention

The present invention can provide a film mirror for reflecting sunlight which can be manufactured with simple production equipment and has a high regular reflectance, excellent weather resistance, high abrasion resistance and strong adherence, and a reflective device for solar thermal power generation including the film mirror.

### Brief Description of Drawings

Fig. 1A is a schematic cross-sectional view of an embodiment of a typical layer configuration of a film mirror for reflecting sunlight and a reflective device for solar thermal power generation including the film mirror according to the present invention.
Fig. 1B is a schematic cross-sectional view of another embodiment of a typical layer configuration of a film mirror for reflecting sunlight and a reflective device for solar thermal power generation including the film mirror according to the present invention.
Fig. 1C is a schematic cross-sectional view of another embodiment of a typical layer configuration of a film mirror for reflecting sunlight and a reflective device for solar thermal power generation including the film mirror according to the present invention.
Fig. 2A is a schematic cross-sectional view of a comparative example of a layer configuration of a film mirror for reflecting sunlight.
Fig. 2B is a schematic cross-sectional view of another comparative example of a layer configuration of a film mirror for reflecting sunlight.
Fig. 3 is a schematic diagram showing an internal configuration of an auto-collimator used for measuring spot diameters in examples.

### Description of Embodiments

Embodiments for carrying out the invention will now be described in detail.

As a result of diligent investigations to achieve the above object, the present inventor has made a film mirror for reflecting sunlight including a polymer film substrate, a reflective layer including silver coating, and a protective coating layer in sequence from the incident side of sunlight, the reflective layer being formed by coating and calcining (firing) a coating liquid containing a silver complex compound and found that the film mirror can be manufactured with simple production equipment and has a high regular reflectance, excellent weather resistance, high abrasion resistance, and strong adherence. The present invention is based on this finding.

The film mirror for reflective sunlight according to the present invention will now be described in detail.

### (Configurations of film mirror for reflecting sunlight and reflective device for solar thermal power generation)

The film mirror for reflecting sunlight of the present invention includes a polymer film substrate, a reflective layer including silver coating and a protective coating layer in sequence from the incident side of sunlight.

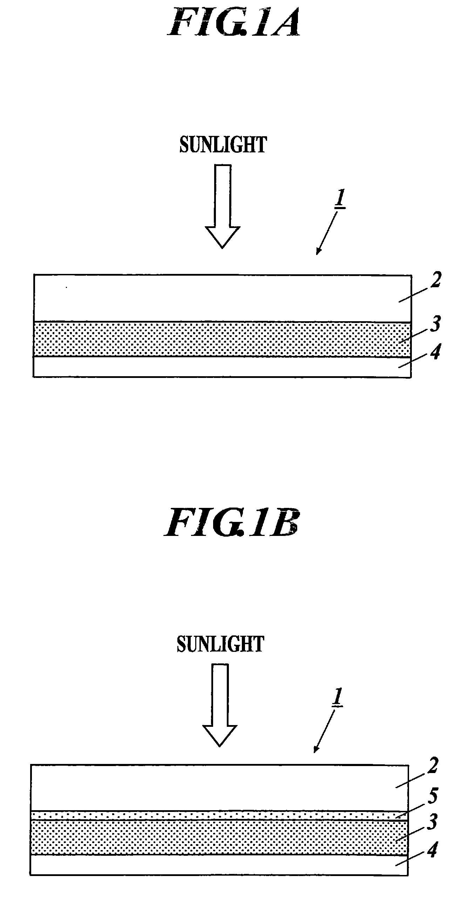

Figs. 1A to 1C are each a schematic cross-sectional view of an embodiment of a typical layer configuration of a film mirror for reflecting sunlight and a reflective device for solar thermal power generation using the film mirror according to the present invention.

Fig. 1A illustrates an embodiment of the configurations of a film mirror for reflecting sunlight according to the present invention.

In the configuration illustrated in Fig. 1A, a film mirror 1 for reflecting sunlight includes, in sequence from the incident side of sunlight (from the top in the drawing), a polymer film substrate 2, a reflective layer 3 including silver coating formed by coating and calcining (firing) a coating liquid containing a silver complex compound, and a protective coating layer 4 blocking the open air to protect the reflective layer 3 including the silver coating.

As defined in the present invention, the polymer film substrate 2 having an extremely smooth surface is disposed to the incident side of sunlight, and a coating solution containing a silver complex compound is coated by a wet coating process thereon to form the reflective layer 3. The structure renders the sunlight reflecting surface of the reflective layer 3 in contact with the polymer film substrate 2 extremely smooth with a high regular reflectance. Furthermore, the reflective layer 3, which is isolated from the open air by the polymer film substrate 2 and the protective coating layer 4, has excellent durability and further has a high light resistance by virtue of the polymer film substrate 2 disposed on the incident side of the sunlight.

In Fig. 1B illustrating the film mirror for reflecting the sunlight 1, a primer layer 5 is disposed between the polymer film substrate 2 and the reflective layer 3 including silver coating according to the present invention to improve the adherence between the polymer film substrate 2 and the reflective layer 3. In such a configuration, preferably the thickness of the primer layer 5 is as thin as possible from the viewpoint of transferring the surface profile of the polymer film substrate 2 having high surface smoothness to the surface of the reflective layer 3 without impairing such a profile. Accordingly, the primer layer 5 has a thickness of preferably 10 nm or more and 1.0 µm or less.

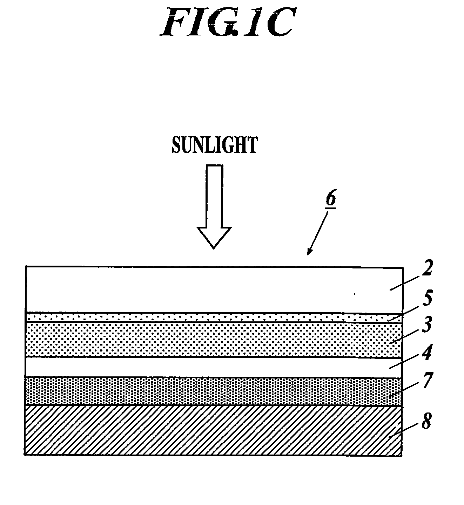

Fig. 1C is a schematic cross-sectional view of an embodiment of typical layer configurations of a reflective device for solar thermal power generation including a film mirror for reflecting sunlight of the present invention.

The reflective device for solar thermal power generation 6 is formed by fixing the film mirror for reflecting sunlight 1 shown in Fig. 1B to the holding member 8 (e.g., a metal member such as an aluminum support) through (by) the adhesive layer 7.

### (Film mirror for reflecting sunlight)

Each component in the film mirror for reflecting sunlight of the present invention will now be described.

### (Polymer film substrate)

Preferred examples of the material for polymer film substrate include monolayer films and co-extruded films that are composed of any one of polyesters, polyethylene terephthalate, polyethylene naphthalate, acrylic resins, polycarbonates, polyolefins (in particular, cycloolefin resins), cellulose, and polyamides from the viewpoint of flexibility and weight reduction. In particular, acrylic copolymers made of two or more acrylic monomers and cycloolefin resins are preferred in view of excellent weather resistance.

Examples of the preferred acrylic copolymers include acrylic copolymers having a weight average molecular weight of 40, 000 to 1, 000, 000, preferably 100, 000 to 400, 000 and prepared through copolymerization such as solution, suspension, emulsion or bulk polymerization, of one or more main monomer components having no pendant functional group (hereafter referred to as non-functional monomers), such as alkyl (meth) acrylates (e.g., methyl acrylate, ethyl acrylate, propyl acrylate, butyl acrylate, 2-ethylhexyl acrylate, 2-hydroxyethyl acrylate, methyl methacrylate, ethyl methacrylate, propyl methacrylate, butyl methacrylate, cyclohexyl methacrylate and 2-ethylhexyl methacrylate) in combination with one or more monomers having pendant functional groups such as OH and COOH (hereafter referred to as functional monomers), which are selected from 2-hydroxyethyl methacrylate, glycidyl methacrylate, acrylic acid, methacrylic acid, and itaconic acid. Among them, the most preferred are acrylic copolymers prepared through copolymerization of 50 to 90 mass% of a non-functional monomer or monomers which give polymers having relatively low Tg, such as ethyl acrylate, methyl acrylate, and 2-ethylhexyl methacrylate; 10 to 50 mass% of non-functional monomer or monomers which give polymers having relatively high Tg, such as methyl methacrylate, isobutyl methacrylate, and cyclohexyl methacrylate; and 0 to 10 mass% of a functional monomer or monomers such as 2-hydroxyethyl methacrylate, acrylic acid, and itaconic acid.

Furthermore, the cycloolefin resin which can be suitably used in the polymer film substrate according to the present invention includes a polymer resin containing an alicyclic structure. A preferred cycloolefin resin is formed by polymerization or copolymerization of a cyclic olefin. Examples of the cyclic olefin include unsaturated hydrocarbons having a polycyclic structure, e.g., norbornene, dicyclopentadiene, tetracyclododecene, ethyltetracyclododecene, ethylydenetetracyclododecene, and tetracyclo[7.4.0.110,13.02,7]trideca-2,4,6,11-tetraene, and derivatives thereof; and unsaturated hydrocarbons having a monocyclic structure, e.g., cyclobutene, cyclopentene, cyclohexene, 3,4-dimethylcyclopentene, 3-methylcyclohexene, 2-(2-methylbutyl)-1-cyclohexene, cyclooctene, 3a,5,6,7a-tetrahydro-4,7-methano-1H-indene, cycloheptene, cyclopentadiene and cyclohexadiene, and derivatives thereof.

Preferred cycloolefin resins may be additive copolymers with monomers other than the cyclic olefins. Examples of the monomer capable of additive copolymerization with the cyclic olefins include ethylene and α-olefins such as propylene, 1-butene and 1-pentene; and dienes such as 1,4-hexadiene, 4-methyl-1,4-hexadiene, 5-methyl-1,4-hexadiene, and 1,7-octadiene.

The cycloolefin resin also includes the following norbornene-based resins. The norbornene-based resins preferably have a norbornene skeleton as a repeating unit, and specific examples thereof include, but are not limited to, those described in Japanese Unexamined Patent Application Publication Nos. 2003-139950, 2003-14901, 2003-161832, 2003-195268, 2003-211588, 2003-211589, 2003-268187, 2004-133209, 2004-309979, 2005-121813, 2005-164632, 2006-72309, 2006-178191, 2006-215333, 2006-268065, and 2006-299199. Furthermore, these resins may be used alone or in combination. To be more specific, cycloolefin resins such as Zeonex(TM) and Zeonor(TM) manufactured by Zeon Co., Ltd., Arton(TM) manufactured by JSR Co. , Ltd., and Apel (TM) (APL8008T, APL6509T, APL6013T, APL5014DP, APL6015T) manufactured by Mitsui Chemicals, Inc. are preferably used.

The polymer film has a thickness of, but not particularly limited to, preferably 9 µm or more and 175 µm or less, and more preferably 12 µm or more and 100 µm or less.

A thickness of the film of 9 µm or more can prevent wrinkling or breakage of the film during the processing of the film mirror for reflecting sunlight. A thickness of the film of 175 µm or less can prevent uneven thickness or sagging, resulting in a highly uniform substrate.

The surface of the polymer film substrate may be subj ected to corona or plasma discharge treatment to improve its adherence to the reflective layer or the primer layer.

### (UV absorber)

The polymer film substrate according to the present invention preferably contains a UV absorber in view of improvements in weather resistance and light resistance. Preferably the UV absorber used in the polymer film substrate according to the present invention absorbs UV light of a wavelength of 370 nm or less as much as possible, while it absorbs visible light of a wavelength of 400 nm or more as little as possible in view of utilization of sunlight.

Examples of the UV absorber used in the present invention include oxybenzophenone compounds, benzotriazole compounds, salicylic ester compounds, benzophenone compounds, cyanoacrylate compounds, nickel-complex salt compounds, and triazine compounds. Among them, preferred are benzophenone compounds, and benzotriazole compounds and triazine compounds which cause little coloration. Furthermore, UV absorbers disclosed in Japanese Unexamined Patent Application Publication Nos. Hei-10-182621 and Hei-8-337574, and polymer UV absorbers described in Japanese Unexamined Patent Application Publication Nos. Hei-6-148430 and 2003-113317 can also be used.

Examples of benzotriazole UV absorbers include, but are not limited to, 2-(2'-hydroxy-5'-methylphenyl)benzotriazole,
2-(2'-hydroxy-3',5'-di-tert-butylphenyl)benzotriazole,
2-(2'-hydroxy-3'-tert-butyl-5'-methylphenyl)bensotriazole,
2-(2'-hydroxy-3',5'-di-tert-butylphenyl)-5-chlorobenzotriaz ole,
2-(2'-hydroxy-3'-(3",4",5",6"-tetrahydrophthalimidomethyl)-5'-methylphenyl)benzotriazole,
2,2-methylenebis(4-(1,1,3,3-tetramethylbutyl)-6-(2H-benzotr iazole-2-yl)phenol), 2-(2'-hydroxy-3'-tert-butyl-5'-methylphenyl)-5-chlorobenzot riazole, 2-(2'-hydroxy-3'-tert-butyl-5'-(2-octyloxycarbonyl ethyl)-phenyl)-5-chlorobenzotriazole,
2-(2'-hydroxy-3'-(1-methyl-1-phenylethyl)-5'-(1,1,3,3-tetra methylbutyl)-phenyl)benzotriazole,
2-(2H-benzotriazole-2-yl)-6-(straight chain and branched chain dodecyl)-4-methylphenols, and a mixture of octyl-3-[3-tert-butyl-4-hydroxy-5-(chloro-2H-benzotriazole-2-yl)phenyl] propionate and
2-ethylhexyl-3-[3-tert-butyl-4-hydroxy-5-(5-chloro-2H-benzo triazole-2-yl)phenyl] propionate.

Examples of commercially available UV absorbers include TINUVIN(TM) 171, TINUVIN(TM) 900, TINUVIN(TM) 928, and TINUVIN(TM) 360 (all produced by Ciba Japan Co., Ltd.); LA 31 (produced by ADEKA Corporation); and RUVA(TM)-100 (Otsuka Chemical Co., Ltd.).

Examples of benzophenone compounds include, but are not limited to, 2,4-dihydroxybenzophenone, 2,2'-dihydroxy-4-methoxybenzophenone, 2-hydroxy-4-methoxy-5-sulfobenzophenone, and bis(2-methoxy-4-hydroxy-5-benzoylphenylmethane).

### (Antioxidant and stabilizer)

The polymer film substrate according to the present invention preferably contains an antioxidant or stabilizer. Examples of the antioxidant used in the polymer film substrate according to the present invention include phenolic antioxidants, thiol antioxidants, and phosphite antioxidants.

Examples of the phenolic antioxidant include 1,1,3-tris(2-methyl-4-hydroxy-5-t-butylphenyl)butane, 2,2'-methylenebis(4-ethyl-6-t-butylphenol), tetrakis[methylene-3-(3',5'-di-t-butyl-4'-hydroxyphenyl) propionate]methane, 2,6-di-t-butyl-p-cresol, 4,4'-thiobis(3-methyl-6-t-butylphenol), 4,4'-butylidenebis(3-methyl-6-t-butylphenol), 1,3,5-tris(3',5'-di-t-butyl-4'-hydroxybenzyl)-S-triazine-2, 4,6-(1H,3H,5H)trione, stearyl-β-(3,5-di-t-butyl-4-hydroxyphenyl)propionate, triethylene glycol bis[3-(3-t-butyl-5-methyl-4-hydroxyphenyl)propionate], 3,9-bis[1,1-di-methyl-2-[β-(3-t-butyl-4-hydroxy-5-methyl phenyl)propionyloxy]ethyl]-2,4,8,10-tetraoxaspiro[5,5] undecane, 1,3,5-trimethyl-2,4,6-tris(3,5-di-t-butyl-4-hydroxybenzyl) benzene. In particular, the molecular weight of the phenolic antioxidant is preferably 550 or more.

Examples of the thiol antioxidant include distearyl 3,3'-thiodipropionate, and pentaerythritol tetrakis (β-lauryl-thiopropionate) .

Examples of phosphite antioxidants include tris(2,4-di-t-butylphenyl) phosphite, distearyl pentaerythritol diphosphite, di-(2,6-di-t-butylphenyl) pentaerythritol diphosphite, bis(2,6-di-t-butyl-4-methylphenyl) pentaerythritol diphosphite, tetrakis(2,4-di-t-butylphenyl) 4,4'-biphenylene diphosphonite, and 2,2'-methylenebis(4,6-di-t-butylphenyl) octyl phosphite.

In the polymer film substrate according to the present invention, the following light stabilizers can be used in combination with the above-described antioxidants.

Examples of the hindered amine light stabilizer include bis(2,2,6,6-tetramethyl-4-piperidyl) sebacate, bis(1,2,2,6,6-pentamethyl-4-piperidyl) sebacate, bis(1,2,2,6,6-pentamethyl-4-piperidyl)-2-(3,5-di-t-butyl-4-hydroxybenzyl)-2-n-butyl malonate, 1-methyl-8-(1,2,2,6,6-pentamethyl-4-piperidyl) sebacate, 1-[2-[3-(3,5-di-t-butyl-4-hydroxyphenyl)propionyloxy]ethyl] -4-[3-(3,5-di-t-butyl-4-hydroxyphenyl)propionyloxy]-2,2,6,6 -tetramethylpiperidine, 4-benzoyloxy-2,2,6,6-tetramethylpiperidine, tetrakis(2,2,6,6-tetramethyl-4-piperidyl) 1,2,3,4-butane-tetracarboxylate, triethylenediamine, and 8-acetyl-3-dodecyl-7,7,9,9-tetramethyl-1,3,8-triazaspiro[4, 5]decane-2,4-dione.

Examples of the nickel-based UV stabilizers include [2,2'-thiobis(4-t-octyl phenolate)]-2-ethylhexylamine nickel(II), nickel complex-3,5-di-t-butyl-4-hydroxybenzyl phosphoric acid monoethylate, and nickel dibutyldithiocarbamate.

Examples of the particularly preferred hindered amine light stabilizers, which contain no other amino groups except tertiary amino groups, include bis(1,2,2,6,6-pentamethyl-4-piperidyl) sebacate, bis(1,2,2,6,6-pentamethyl-4-piperidyl) 2-(3,5-di-t-butyl-4-hydroxybenzyl)-2-n-butylmalonate, and condensation products of 1,2,2,6,6-pentamethyl-4-piperidinol/tridecylalcohol with 1,2,3,4-butanetetracarboxylic acid.

### (Reflective layer)

The film mirror for reflecting sunlight of the present invention includes a reflective layer including silver coating on a polymer film substrate, the reflective layer being formed by coating and calcining a coating liquid containing a silver complex compound.

In the film mirror for reflecting sunlight of the present invention, as described above, the polymer film substrate having an extremely smooth surface is disposed to the incident side of sunlight, and a coating solution containing a silver complex compound is coated by a wet coating process thereon and is calcined (fired) to form a reflective layer. This process allows the surface of the reflective layer in contact with the sunlight reflecting surface of the polymer film substrate to be provided with an extremely smooth reflecting surface having a high regular reflectance.

Any reflective layer which is formed with a coating liquid containing a silver complex compound can be used without limitation in the present invention. Preferably, the silver complex compound to be used is prepared by the reaction of a silver compound represented by Formula (1) with at least one selected from the compounds represented by Formulae (2) to (4).

### (Compounds represented by Formulae (1) to (4))

The silver compounds represented by Formula (1) and compounds represented by Formulae (2) to (4) will now be described in detail.

The silver compounds represented by Formula (1) will be described.

Formula (1) AgₙX

In Formula (1), X represents at least one selected from the group consisting of an oxygen atom, a sulfur atom, a halogen atom, a cyano group, a cyanate group, a carbonate group, a nitrate group, a nitrite group, a sulfate group, a phosphate group, a thiocyanate group, a chlorate group, a perchlorate group, a tetrafluoroborate group, an acetylacetonate group, a carboxylate group, and derivatives thereof. Specific examples include, but are not limited to, silver oxide, silver thiocyanate, silver sulfide, silver chloride, silver cyanide, silver cyanate, silver carbonate, silver nitrate, silver nitrite, silver sulfate, silver phosphate, silver perchlorate, silver tetrafluoroborate, silver acetylacetonate, silver acetate, silver lactate, silver oxalate, and derivatives thereof, and n represents an integer of 1 to 4.

Compounds represented by Formulae (2) to (4) will now be described.

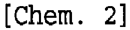

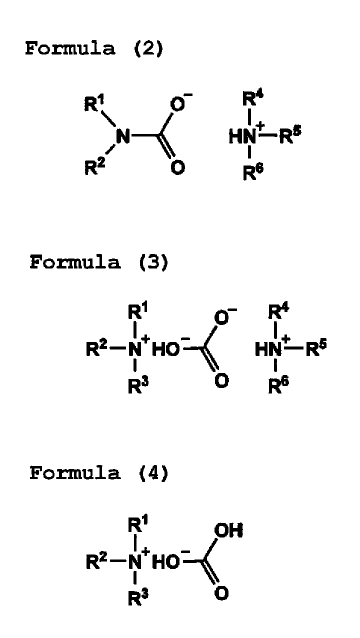

In Formulae (2) to (4), R¹ to R⁶ each independently represent at least one substituent selected from the group consisting of a hydrogen atom, an aliphatic alkyl group having 1 to 30 carbon atoms, an alicyclic alkyl group having 1 to 30 carbon atoms, an aryl group, an aralkyl group, a substituted alkyl group, a substituted aryl group, a heterocyclic group, a polymer group, and derivatives thereof.

Examples of the groups represented by R¹ to R⁶ include, but are not limited to, a hydrogen atom; groups such as methyl, ethyl, propyl, isopropyl, butyl, isobutyl, amyl, hexyl, ethylhexyl, heptyl, octyl, isooctyl, nonyl, decyl, dodecyl, hexadecyl, octadecyl, docodecyl, cyclopropyl, cyclopentyl, cyclohexyl, aryl, hydroxy, methoxy, hydroxyethyl, methoxyethyl, 2-hydroxy propyl, methoxypropyl, cyanoethyl, ethoxy, butoxy, hexyloxy, methoxyethoxyethyl, methoxyethoxyethoxyethyl, hexamethyleneimine, morpholine, piperidine, piperazine, ethylenediamine, propylenediamine, hexamethylenediamine, triethylenediamine, pyrrole, imidazole, pyridine, carboxymethyl, trimethoxysilylpropyl, triethoxysilylpropyl, phenyl, methoxyphenyl, cyanophenyl, phenoxy, tolyl, benzyl groups, and derivatives thereof; and polymer groups, such as polyarylamine and polyethyleneimine, and derivatives thereof.

Examples of the specific compound include, but are not limited to, a compound or a mixture of two or more compounds selected from the group consisting of ammonium carbamate, ammonium carbonate, ammonium bicarbonate, ethylammonium ethylcarbamate, isopropylammonium isopropylcarbamate, n-butylammonium n-butylcarbamate, isobutylammonium isobutylcarbamate, t-butylammonium t-butylcarbamate, 2-ethylhexylammonium 2-ethylhexylcarbamate, octadecylammonium octadecylcarbamate, 2-methoxyethylammonium 2-methoxyethylcarbamate, 2-cyanoethylammonium 2-cyanoethylcarbamate, dibutylammonium dibutylcarbamate, dioctadecylammonium dioctadecylcarbamate, methyldecylammonium methyldecylcarbamate, hexamethyleneimineammonium hexamethyleneiminecarbamate, morpholinium morpholinecarbamate, pyridinium ethylhexylcarbamate, triethylenediaminium isopropylbicarbamate, benzylammonium benzylcarbamate, triethoxysilylpropylammonium triethoxysilyl propylcarbamate, ethylammonium ethylcarbonate, isopropylammonium isopropylcarbonate, isopropylammonium bicarbonate, n-butylammonium n-butylcarbonate, isobutylammonium isobutylcarbonate, t-butylammonium t-butylcarbonate, t-butylammonium bicarbonate, 2-ethylhexylammonium 2-ethylhexylcarbonate, 2-ethylhexylammonium bicarbonate, 2-methoxyethylammonium 2-methoxyethylcarbonate, 2-methoxyethylammonium bicarbonate, 2-cyanoethylammonium 2-cyanoethylcarbonate, 2-cyanoethylammonium bicarbonate, octadecylammonium octadecylcarbonate, dibutylammonium dibutylcarbonate, dioctadecylammonium dioctadecylcarbonate, dioctadecylammonium bicarbonate, methyldecylammonium methyldecylcarbonate, hexamethyleneimineammonium hexamethyleneiminecarbonate, morpholineammonium morpholinecarbonate, benzylammonium benzylcarbonate, triethoxysilylpropylammonium triethoxysilylpropylcarbonate, pyridinium bicarbonate, triethylenediaminium isopropylcarbonate, triethylenediaminium bicarbonate, and derivatives thereof.

Meantime, the types of the ammonium carbamate compounds or ammonium carbonate compounds and the methods of manufacturing these compounds are not particularly limited. For example, U.S. Patent No. 4,542,214 (September 17, 1985) discloses that ammonium carbamate compounds can be prepared from primary amine, secondary amine, tertiary amine or at least one of these compounds and carbon dioxide. Ammonium carbonate compounds can be prepared in the case where another 0.5 mol of water is added to 1 mol of amine, while ammonium bicarbonate compounds can be prepared in the case where at least 1 mol of water is added to 1 mol of amine. The preparation can be carried out with or without solvent under normal pressure or increased pressure. Examples of the solvent used include water, alcohols such as methanol, ethanol, 2-propanol, and butanol; glycols such as ethylene glycol and glycerin; acetates such as ethyl acetate, butyl acetate, and carbitol acetate; ethers such as diethyl ether, tetrahydrofuran, and dioxane; ketones such as methyl ethyl ketone and acetone; hydrocarbons such as hexane and heptane; aromatic compounds such as benzene and toluene; halogen substituted solvents such as chloroform, methylene chloride, and carbon tetrachloride; or mixed solvents thereof. Carbon dioxide may be reacted in a gaseous state by bubbling or in a solid state (dry ice) as well as in a supercritical state. Any other known methods can be employed for the preparation of the ammonium carbamate derivatives and the ammonium carbonate derivatives if the structure of the target compound is the same. In other words, conditions for manufacturing such as solvent, reaction temperature, concentration, and catalyst are not particularly required to be limited, and a preparation yield does not cause a matter of availability.

Organic silver complexes can be manufactured by the reaction of ammonium carbamate compounds or ammonium carbonate compounds with silver compounds. For example, at least one silver compound as shown in Formula (1) may be reacted with at least one of ammonium carbamate derivatives or ammonium carbonate derivatives as shown in Formulae (2) to (4) or a mixture thereof with or without solvent under normal pressure or increased pressure in nitrogen gas. Examples of the solvent used include water; alcohols such as methanol, ethanol, 2-propanol and butanol; glycols such as ethylene glycol and glycerin; acetates such as ethyl acetate, butyl acetate and carbitol acetate; ethers such as diethyl ether, tetrahydrofuran and dioxane; ketones such as methyl ethyl ketone and acetone, hydrocarbons such as hexane and heptanes; aromatic solvents such as benzene and toluene; and halogen substituted solvents such as chloroform, methylene chloride, carbon tetrachloride; and mixtures thereof.

Another method of manufacturing the silver complex used in the present invention, besides the above-described methods, involves preparation of a mixed solution of silver compound represented by Formula (1) according to the present invention and at least one amine compound, and then reaction of the mixed solution with carbon dioxide to give a silver complex compound. As described above, either the direct reaction without solvent or the reaction with solvent can be conducted under normal pressure or increased pressure in nitrogen gas. Any known method can be employed if the structure of the target compound is the same. More specifically, any manufacturing conditions such as solvent, reaction temperature, concentration, and the presence or absence of catalyst can be employed without restriction and a production yield does not cause a matter of availability.

Examples of the silver complex compound used in the present invention may include specific silver complex compounds, represented by Formula (5), which are described in Japanese Unexamined Patent Application Publication No. 2008-530001.

Formula (5) Ag(A)m

In Formula (5), A is a compound represented by Formulae (2) to (4), and m is 0.5 to 1.5.

The coating liquid for forming a reflective layer used for forming the reflective layer with high reflectance and high gloss according to the present invention includes the silver complex compound according to the present invention, and, if necessary, can contain other additives such as a solvent, stabilizer, leveling agent, film adjuvant, reducing agent, and pyrolysis promoter.

Examples of the stabilizer used in the coating liquid for forming a reflective layer include amine compounds such as primary amine, secondary amine, and tertiary amine; the ammonium carbamate compounds, ammonium carbonate compounds, and ammonium bicarbonate compounds; phosphorus compounds such as phosphines, phosphites, and phosphates; sulfur compounds such as thiols and sulfides; and mixtures thereof. Examples of the amine compound include methylamine, ethylamine, n-propylamine, isopropylamine, n-butylamine, isobutylamine, isoamylamine, n-hexylamine, 2-ethylhexylamine, n-heptylamine, n-octylamine, isooctylamine, nonylamine, decylamine, dodecylamine, hexadecylamine, octadecylamine, docodecylamine, cyclopropylamine, cyclopentylamine, cyclohexylamine, arylamine, hydroxyamine, ammonium hydroxide, methoxyamine, 2-ethanolamine, methoxyethylamine, 2-hydroxypropylamine, 2-hdroxy-2-methylpropylamine, methoxypropylamine, cyanoethylamine, ethoxyamine, n-butoxyamine, 2-hexyloxyamine, methoxyethoxyethylamine, methoxyethoxyethoxyethylamine, dimethylamine, dipropylamine, diethanolamine, hexamethyleneimine, morpholine, piperidine, piperazine, ethylenediamine, propylenediamine, hexamethylenediamine, triethylenediamine, 2,2-(ethylenedioxy)bisethylamine, triethylamine, triethanolamine, pyrrole, imidazole, pyridine, aminoacetaldehyde dimethyl acetal, 3-aminopropyltrimethoxysilane, 3-aminopropyltriethoxysilane, aniline, anisidine, aminobenzonitrile, benzylamine, derivatives thereof, polymeric compounds such as polyarylamine and polyethyleneimine, and derivatives thereof.

Examples of the ammonium carbamate compounds, ammonium carbonate compounds, and ammonium bicarbonate compounds include ammonium carbamate, ammonium carbonate, ammonium bicarbonate, ethylammonium ethylcarbamate, isopropylammonium isopropylcarbamate, n-butylammonium n-butylcarbamate, isobutylammonium isobutylcarbamate, t-butylammonium t-butylcarbamate, 2-ethylhexylammonium 2-ethylhexylcarbamate, octadecylammonium octadecylcarbamate, 2-methoxyethylammonium 2-methoxyethylcarbamate, 2-cyanoethylammonium 2-cyanoethylcarbamate, dibutylammonium dibutylcarbamate, dioctadecylammonium dioctadecylcarbamate, methyldecylammonium methyldecylcarbamate, hexamethyleneimineammonium hexamethyleneiminecarbamate, morpholinium morpholinecarbamate, pyridinium ethylhexylcarbamate, triethylenediaminium isopropylcarbamate, benzylammonium benzylcarbamate, triethoxysilylpropylammonium triethoxysilylpropylcarbamate, ethylammonium ethylcarbonate, isopropylammonium isopropylcarbonate, isopropylammonium bicarbonate, n-butylammonium n-butylcarbonate, isobutylammonium isobutylcarbonate, t-butylammonium t-butylcarbonate, t-butylammonium bicarbonate, 2-ethylhexylammonium 2-ethylhexylcarbonate, 2-ethylhexylammonium bicarbonate, 2-methoxyethylammonium 2-methoxyethylcarbonate, 2-methoxyethylammonium bicarbonate, 2-cyanoethylammonium 2-cyanoethylcarbonate, 2-cyanoethylammonium bicarbonate, octadecylammonium octadecylcarbonate, dibutylammonium dibutylcarbonate, dioctadecylammonium dioctadecylcarbonate, dioctadecylammonium bicarbonate, methyldecylammonium methyldecylcarbonate, hexamethyleneimineammonium hexamethyleneiminecarbonate, morpholinammonium, morpholinecarbonate, benzylammonium benzylcarbonate, triethoxysilylpropylammonium triethoxysilylpropylcarbonate, pyridinium bicarbonate, triethylenediaminium isopropylcarbonate, triethylenediaminium bicarbonate, and derivatives thereof.

Furthermore, the phosphorus compound may be represented by a general formula R₃P, (RO)₃P, or (RO)₃PO, wherein R is an alkyl or aryl group having 1 to 20 carbon atoms. Specific examples of such a phosphorus compound include tributylphosphine, triphenylphosphine, triethyl phosphite, triphenyl phosphite, dibenzyl phosphate, and triethyl phosphate.

Examples of the sulfur compound may include butanethiol, n-hexanethiol, diethyl sulfide, tetrahydrothiophene, aryl disulfide, 2-mercaptobenzothiazole, tetrahydrothiophene, and octyl thioglycolate.

Such stabilizers can be used in appropriate amount without limitation, and preferably in a molar ratio of 0.1% to 90% to silver compounds.

Examples of the film adjuvants which can be used for the coating liquid for forming a reflective layer include organic acids, organic acid derivatives, or mixtures thereof. The examples of the organic acid include acetic acid, butyric acid, valeric acid, pivalic acid, hexanoic acid, octanoic acid, 2-ethylhexanoic acid, neodecanoic acid, lauric acid, stearic acid, and naphthalic acid. The examples of the organic acid derivatives include ammonium salts of organic acids such as ammonium acetate, ammonium citrate, ammonium laurate, ammonium lactate, ammonium maleate, ammonium oxalate, and ammonium molibdate; and metal salts of organic acids, which include metals such as Au, Cu, Zn, Ni, Co, Pd, Pt, Ti, V, Mn, Fe, Cr, Zr, Nb, Mo, W, Ru, Cd, Ta, Re, Os, Ir, Al, Ga, Ge, In, Sn, Sb, Pb, Bi, Sm, Eu, Ac, and Th, e.g., manganese oxalate, gold acetate, palladium oxalate, silver 2-ethylhexanoate, silver octanoate, silver neodecanoate, cobalt stearate, nickel naphthalate, and cobalt naphthalate. The molar ratio of film adjuvants to silver complexes is preferably, but not limited to, 0.1% to 25%.

The reducing agent used in the coating liquid for forming a reflective layer includes Lewis acid or weak Bronsted acid. Examples of the reducing agent include amine compounds such as hydrazine, hydrazine monohydrate, acethydrazide, sodium borohydride or potassium borohydride, dimethylamine borane, and butylamine borane; metal salts such as ferrous chloride and iron lactate; hydrogen; hydrogen iodide; carbon monoxide; aldehyde compounds such as formaldehyde, acetaldehyde, and glyoxal; formate compounds such as methyl formate, butyl formate, and triethyl orthoformate; reducing organic compounds such as glucose, ascorbic acid, and hydroquinone; and mixtures thereof.

Examples of the pyrolysis promoter used in the coating liquid for forming a reflective layer include hydroxyalkylamines such as ethanolamine, methyldiethanolamine, triethanolamine, propanolamine, butanolamine, hexanolamine, and dimethylethanolamine; amine compounds such as piperidine, N-methylpiperidine, piperazine, N,N'-dimethylpiperazine, 1-amino-4-methylpiperazine, pyrrolidine, N-methylpyrrolidine, and morpholine; alkyl oximes such as acetone oxime, dimethylglyoxime, 2-butanone oxime, and 2,3-butadione monooxime; glycols such as ethylene glycol, diethylene glycol, and triethylene glycol; alkoxyalkylamines such as methoxyethylamine, ethoxyethylamine, and methoxypropylamine; alkoxyalkanols such as methoxyethanol, methoxypropanol, and ethoxyethanol; ketones such as acetone, methyl ethyl ketone, and methyl isobutyl ketone; ketone alcohols such as acetol and diacetone alcohol; polyphenol compounds; phenol resins, alkyd resins, and resins prepared by oxidative polymerization of monomers such as pyrrole and ethylenedioxythiophene (EDOT).

Solvent is necessary in some cases for viscosity control of the coating liquid for forming a reflective layer and smooth formation of a thin film from the liquid. Examples of the solvent used herein include water; alcohols such as methanol, ethanol, 2-propanol, 1-methoxypropanol, butanol, ethylhexyl alcohol, and terpineol; glycols such as ethylene glycol and glycerin; acetates such as ethyl acetate, butyl acetate, methoxypropyl acetate, carbitol acetate, and ethylcarbitol acetate; ethers such as methyl cellosolve, butyl cellosolve, diethyl ether, tetrahydrofuran, and dioxane; ketones such as methyl ethyl ketone, acetone, dimethylformamide, and 1-methyl-2-pyrrolidone; hydrocarbon solvents such as hexane, heptane, dodecane, paraffin oil, and mineral spirit; aromatic hydrocarbon solvents such as benzene, toluene and xylene; halogenated solvents such as chloroform, methylene chloride, and carbon tetrachloride; acetonitrile; dimethyl sulfoxide; and mixtures thereof.

The process of forming the reflective layer according to an embodiment of the present invention using the coating liquid for forming a reflective layer will now be described.

In the present invention, any wet coating process can be employed for coating a coating liquid for forming a reflective layer containing a silver complex compound according to the present invention on a polymer film substrate to form a reflective layer, and the process used can be appropriately selected from known coating processes which use a coating solution, such as spin coating, dip coating, extrusion coating, roll coating, spray coating, gravure coating, wire bar coating, air knife coating, slide hopper coating, curtain coating, screen printing, and ink jet printing.

The reflective layer is formed on a polymer film substrate according to the above-described process, and then calcined to form a reflective mirror surface.

The calcination may be conducted by heat treatment in a typical inert atmosphere. If necessary, it can also be conducted in an atmosphere of air, nitrogen, carbon monoxide, a mixture of hydrogen and air, or a mixture of hydrogen and another inert gas. Although the adequate temperature of the heat treatment depends on the material of the polymer film substrate, the heat treatment may be conducted typically in the range of 80 to 400°C, preferably 90 to 300°C, and more preferably 100 to 250°C. Furthermore, the heat treatment may preferably involve two or more steps at low and high temperatures within the temperature range described above in view of improving the uniformity of the reflective film. For example, the heat treatment may be conducted at 80 to 150°C for 1 to 30 minutes and then at 150 to 300°C for 1 to 30 minutes.

### (Protective coating layer)

The film mirror for reflecting sunlight of the present invention includes a protective coating layer on the reflective layer.

The protective coating layer including a corrosion inhibitor prevents the corrosive degradation of metal, e.g., silver, which constitutes the reflective layer, and also contributes to improve the adherence to an adhesive layer which is formed thereon when the reflective device for solar thermal power generation is provided.

Examples of the resin usable for formation of the protective coating layer may include polyester resins, acrylic resins, melamine resins, and epoxy resins, which are used alone or in combination. The polyester resins and acrylic resins are preferred from the viewpoint of weather resistance. More preferred are thermosetting resins including curing agents such as isocyanate.

Various known isocyanates can be used, such as tolylene diisocyanate (TDI), xylene diisocyanate (XDI), methylene diisocyanate (MDI), and hexamethylene diisocyanate (HMDI). XDI, MDI, and HMDI are preferred from the viewpoint of weather resistance.

The protective coating layer has a thickness of preferably 0.01 to 3 µm, and more preferably 0.1 to 1 µm in view of, for example, adherence and weather resistance.

The protective coating layer can be formed by any known coating process, for example gravure coating, reverse coating, or die coating.

The corrosion inhibitors preferably used for the reflective layer in the protective coating layer according to the present invention are roughly classified into inhibitors having an adsorptive group to silver and antioxidants. The term "corrosion" refers to a phenomenon of chemical or electrochemical erosion or material degradation of metal (e.g., silver) by the action of environmental substances surrounding the metal (see JIS Z0103-2004).

In another preferred embodiment of the film mirror according to the present invention, the primer layer contains an antioxidant and the protective coating layer contains a corrosion inhibitor having an adsorptive group to silver.

Furthermore, the optimum amount of the corrosion inhibitor, which may vary depending on the type of the inhibitor used, is typically in the range of 0.1 to 1.0 g/m².

### (Corrosion inhibitor having adsorptive group to silver)

The corrosion inhibitor having an adsorptive group to silver that can be used in the present invention is preferably at least one compound selected from the group consisting of amines and derivatives thereof, compounds having pyrrole rings, compounds having triazole rings, compounds having pyrazole rings, compounds having thiazole rings, compounds having imidazole rings, compounds having indazole rings, copper chelate compounds, thioureas, compounds having mercapto groups, and naphthalene compounds, and mixtures thereof.

Examples of the amines and derivatives thereof include ethylamine, laurylamine, tri-n-butylamine, o-toluidine, diphenylamine, ethylenediamine, diethylenetriamine, triethylenetetramine, tetraethylenepentamine, monoethanolamine, diethanolamine, triethanolamine, N,N-dimethylethanolamine, 2-amino-2-methyl-1,3-propanediol, acetamide, acrylamide, benzamide, p-ethoxychrysoidine, dicyclohexylammonium nitrite, dicyclohexylammonium salicylate, monoethanolamine benzoate, dicyclohexylammonium benzoate, diisopropylammonium benzoate, diisopropylammonium nitrite, cyclohexylamine carbamate, nitronaphthaleneammonium nitrite, cyclohexylamine benzoate, dicyclohexylammonium cyclohexanecarboxylate, cyclohexylamine cyclohexanecarboxylate, dicyclohexylammonium acrylate, cyclohexylamine acrylate, and mixtures thereof.

Examples of the compound having a pyrrole ring include N-butyl-2,5-dimethylpyrrole, N-phenyl-2,5-dimethylpyrrole, N-phenyl-3-formyl-2,5-dimethylpyrrole, N-phenyl-3,4-diformyl-2,5-dimethylpyrrole, and mixtures thereof.

Examples of the compound having a triazole ring include 1,2,3-triazole, 1,2,4-triazole, 3-mercapto-1,2,4-triazole, 3-hydroxy-1,2,4-triazole, 3-methyl-1,2,4-triazole, 1-methyl-1,2,4-triazole, 1-methyl-3-mercapto-1,2,4-triazole, 4-methyl-1,2,3-triazole, benzotriazole, tolyltriazole, 1-hydroxybenzotriazole, 4,5,6,7-tetrahydrotriazole, 3-amino-1,2,4-triazole, 3-amino-5-methyl-1,2,4-triazole, carboxybenzotriazole, 2-(2'-hydroxy-5'-methylphenyl)benzotriazole, 2-(2'-hydroxy-5'-tert-butylphenyl)benzotriazole, 2-(2'-hydroxy-3',5'-di-tert-butylphenyl)benzotriazole, 2-(2'-hydroxy-4-octoxyphenyl)benzotriazole, and mixtures thereof.

Examples of the compound having a pyrazole ring include pyrazole, pyrazoline, pyrazolone, pyrazolidine, pyrazolidone, 3,5-dimethylpyrazole, 3-methyl-5-hydroxypyrazole, 4-aminopyrazole, and mixtures thereof.

Examples of the compound having a thiazole ring include thiazole, thiazoline, thiazolone, thiazolidine, thiazolidone, isothiazole, benzothiazole, 2-N,N-diethylthiobenzothiazole, p-dimethylaminobenzalrhodanine, 2-mercaptobenzothiazole, and mixtures thereof.

Examples of the compound having an imidazole ring include imidazole, histidine, 2-heptadecylimidazole, 2-methylimidazole, 2-ethyl-4-methylimidazole, 2-phenylimidazole, 2-undecylimidazole, 1-benzyl-2-methylimidazole, 2-phenyl-4-methylimidazole, 1-cyanoethyl-2-methylimidazole, 1-cyanoethyl-2-phenylimidazole, 1-cyanoethyl-2-ethyl-4-methylimidazole, 1-cyanoethyl-2-undecylimidazole, 2-phenyl-4-methyl-5-hydroxymethylimidazole, 2-phenyl-4,5-dihydroxymethylimidazole, 4-formylimidazole, 2-methyl-4-formylimidazole, 2-phenyl-4-formylimidazole, 4-methyl-5-formylimidazole, 2-ethyl-4-methyl-5-formylimidazole, 2-phenyl-4-methyl-4-formylimidazole, 2-mercaptobenzimidazole, and mixtures thereof.

Examples of the compound having an indazole ring include 4-chloroindazole, 4-nitroindazole, 5-nitroindazole, 4-chloro-5-nitroindazole, and mixtures thereof.

Examples of the copper chelate compounds include copper acetylacetone, copper ethylenediamine, copper phthalocyanine, copper ethylenediaminetetraacetate, copper hydroxyquinoline, and mixtures thereof.

Examples of the thioureas include thiourea, guanylthiourea, and mixtures thereof.

Examples of the compound having a mercapto group, including the materials described above, include mercaptoacetic acid, thiophenol, 1,2-ethanedithiol, 3-mercapto-1,2,4-triazole, 1-methyl-3-mercapto-1,2,4-triazole, 2-mercaptobenzothiazole, 2-mercaptobenzimidazole, glycol dimercaptoacetate, 3-mercaptopropyltrimethoxysilane, and mixtures thereof.

The naphthalene compounds include, for example, thionalide.

The corrosion inhibitor for a reflective layer used in a protective coating layer according to the present invention can be an antioxidant or a stabilizer. Examples of the antioxidants and stabilizers include the same ones used for the polymer film substrate as described above.

### (Primer layer)

The film for reflecting sunlight of the present invention preferably includes a primer layer between a polymer film substrate and a reflective layer in view of improving the adherence between the polymer film substrate and the reflective layer.

The resin used in the primer layer according to the present invention may be any resin that satisfies the requirement of heat resistance and smoothness in addition to the adherence described above. Examples of such polyester resins, acrylic resins, melamine resins, epoxy resins, polyamide resins, vinyl chloride resins, and vinyl chloride/vinyl acetate copolymer resins can be used alone or in combination thereof. The resin is preferably a mixture of polyester resin and melamine resin in view of weather resistance, and more preferably a thermosetting resin mixture including a curing agent such as isocyanate.

In the present invention, the primer layer has a thickness of preferably 0.01 to 3 µm, more preferably 0.1 to 1 µm in view of adherence, smoothness, and reflectance of the reflective layer.

Examples of the process used for formation of the primer layer include the known wet coating processes, such as gravure coating, reverse coating, and die coating.

### (Other components)

The film mirror for reflecting sunlight of the present invention may be, if necessary, provided with each functional layer described below.

### (Anti-scratch layer)

The film mirror for reflecting sunlight of the present invention can be provided with an anti-scratch layer, which is the outermost layer of the film mirror. The anti-scratch layer is disposed to prevent scratching.

The anti-scratch layer can be composed of, for example, acrylic resins, urethane resins, melamine resins, epoxy resins, organic silicate compounds, and silicone resins. In particular, silicone resins and acrylic resins are preferred in view of hardness and durability. Furthermore, the anti-scratch layer composed of active energy beam curable resins or thermosetting acrylic resins is preferred in view of curability, flexibility, and productivity.

The active energy beam curable resin or thermosetting acrylic resin is a composition including a polyfunctional acrylate, acrylic oligomer, or reactive diluent as a polymerizable curing component. The composition can optionally contain additional other additives, such as photoinitiators, photosensitizers, thermal polymerization initiators, and modifiers.

Examples of the acrylic oligomer include oligomers having acrylic backbones provided with reactive acrylic groups; and other oligomers such as polyester acrylates, urethane acrylates, epoxy acrylates, and polyether acrylates. Further examples of the acrylic oligomer used include oligomers having rigid backbones, such as melamine and isocyanuric acid, provided with acrylic groups.

The reactive diluent, which has a group capable of reacting with monofunctional or polyfunctional acrylic oligomers, functions both as a solvent for a coating agent in a coating process and as a copolymerizable component of the anti-scratch layer that can react with the monofunctional or polyfunctional acrylic oligomer.

Examples of the commercially available polyfunctional acrylic curing paints include commercial products such as "DIABEAM (TM) " (trade name) series (Mitsubishi Rayon Co. , Ltd.), "DENACOL(TM)" (trade name) series (Nagase & CO., Ltd.), "NK ester" (trade name) series (Shin-Nakamura Chemical Co., Ltd.), "UNIDIC(TM)" (trade name) series (DIC Corporation), "Aronix(TM)" (trade name) series (TOAGOSEI Co., Ltd.), "BLEMMER(TM)" (trade name) (NOF Corporation), "KAYARAD(TM)" (trade name) series (Nippon Kayaku Co., Ltd.), and "LIGHT ESTER" and "LIGHT ACRYLATE" (trade names) series (Kyoeisha Chemical Co., Ltd.).

In the present invention, the anti-scratch layer can optionally include various additives not impairing the advantageous effects of the invention, for example, antioxidants, light stabilizers, stabilizers (e.g., UV absorbers), surfactants, leveling agents, and antistatic agents.

The leveling agents are particularly effective to reduce surface irregularities in coating of the anti-scratch layer. The preferred leveling agents are silicone leveling agents such as dimethylpolysiloxane-polyoxyalkylene copolymers (e.g., SH190 manufactured by Dow Corning Toray Co., Ltd.).

### (Gas barrier layer)

The film mirror for reflecting sunlight of the present invention can include a gas barrier layer to prevent the film substrate and various functional layers, which are protected by the film substrate, from degradation caused by a variation in humidity, especially high humidity.

In the present invention, the moisture resistance of the gas barrier layer is favorably adjusted in such that the water vapor permeability is 100 g/m²·day/µm or less, preferably 50 g/m²·day/µm or less, and more preferably 20 g/m²·day/µm or less at the condition of 40°C, 90% RH. Furthermore, the oxygen permeability is preferably 0.6 ml/m²/day/atm or less at the measurement condition of 23°C, 90% RH. The vapor permeability can be measured by a vapor permeability tester "PERMATRAN-W (TM) 3-33" manufactured by MOCON, Inc.

The gas barrier layer that can be used in the present invention is primarily composed of metal oxide. Examples of the metal oxide include silicon oxide, aluminum oxide, composite oxide of silicon oxide and aluminum oxide as starting materials, zinc oxide, tin oxide, indium oxide, niobium oxide, and chromium oxide. In particular, silicon oxide, aluminum oxide, and composite oxide of silicon and aluminum are preferred in view of water vapor barrier properties. Furthermore, the gas barrier layer may be a multilayer film composed of an alternate laminate of low refractive index layers having a refractive index of 1.35 to 1.8 at a wavelength of 550 nm and high refractive index layers having a refractive index of 1.85 to 2. 8 at a wavelength of 550 nm. Examples of the low refractive index coating material include silicon oxide, aluminum oxide, silicon nitride, and aluminum nitride. Examples of the high refractive index coating material include niobium oxide, titanium oxide, zinc oxide, tin oxide, indium oxide, tantalum oxide, and zirconium oxide. These layers are formed by a PVD (physical vapor deposition) process such as a vacuum deposition method, sputtering method or ion plating; or a vacuum process such as a CVD (chemical vapor deposition) process. The gas barrier layer composed of the metal oxides preferably has a thickness of 5 to 800 nm, more preferably 10 to 300 nm.

In the present invention, the gas barrier layer composed of silicon oxide, aluminum oxide, or composite oxide of silicon oxide and aluminum oxide on the film substrate has an excellent high barrier effect against gas such as oxygen, carbon dioxide, air, and water vapor.

Furthermore, the layer composed of silicon oxide, aluminum oxide, or composite oxide of silicon oxide and aluminum oxide preferably has a thickness of 1 µm or less and an average light transmittance of 90% or more, which allows for substantially no light loss, i.e., effective reflection of sunlight.

### (Sacrificial anticorrosive layer)

The film mirror for reflecting sunlight of the present invention can be provided with a sacrificial anticorrosive layer. The sacrificial anticorrosive layer according to the present invention refers to a protective layer which protects a reflective layer composed of metal by the action of its own sacrificial corrosion. The sacrificial anticorrosive layer disposed between the reflective layer and the film substrate improves the corrosion resistance of the reflective layer composed of metal. In the present invention, the sacrificial anticorrosive layer is preferably composed of copper, which has a higher ionization tendency than silver. The sacrificial anticorrosive layer can be disposed under the reflective layer composed of silver to reduce the degradation of the silver.

### (Reflective device for solar thermal power generation)

An embodiment of a reflective device for solar thermal power generation including the film mirror for reflecting sunlight of the present invention is now described.

An embodiment of the reflective device for solar thermal power generation of the present invention, as illustrated in Fig. 1C, includes a film mirror 1 for reflecting sunlight fixed to a holding member 8 (e.g., metal member such as an aluminum support) through an adhesive layer 7.

### (Adhesive layer)

The adhesive layer can contain, but not limited to, any one of dry lamination agents, wet lamination agents, adhesive agents, heat sealing agents, and hot melt agents. Specific examples include polyester resins, urethane resins, polyvinyl acetate resins, acrylic resins, and nitrile rubbers.

The method of lamination is not particularly limited, and for example, laminating carried out continuously with a roll laminator is preferred in view of economic efficiency and productivity.

The adhesion layer typically has a thickness in a range of preferably about 1 to 50 µm in view of, for example, adhesive effect and drying speed.

### (Holding member)

The holding member used in a reflective device for solar thermal power generation of the present invention is preferably a metal support. The metal support can be composed of metal material having high thermal conductivity such as a steel sheet, copper sheet, aluminum sheet, aluminum plated steel sheet, aluminum alloy plated steel sheet, copper plated steel sheet, tin plated steel sheet, chrome plated steel sheet, and stainless steel sheet. In the present invention, in particular, a plated steel sheet, stainless steel sheet, and aluminum sheet are preferred in view of a highly corrosion resistance.

### (Reflective device for solar thermal power generation)

The reflective device for solar thermal power generation of the present invention can be used as a film mirror for solar thermal power generation which functions to concentrate sunlight. In an embodiment of the reflective device for solar thermal power generation, the reflector device is shaped into a trough (half cylinder) provided with a tube extending the center of the half circle and filled with fluid therein, and sunlight is concentrated onto the tube to heat the fluid inside it, so that the thermal energy is converted to electricity. In another embodiment, planar reflective devices are installed in several locations. The sunlight beams reflected by each of reflective devices are concentrated onto a single reflector (center reflector). The thermal energy resulted from the reflection by the reflector is converted to electricity by the power generation unit. In particular, the reflective device for solar thermal power generation of the present invention is advantageously used, since a high regular reflectance is required for the reflective device for the latter embodiment. Examples

The present invention will now be specifically described with reference to examples, but the present invention should not be limited thereto. Furthermore, "parts" and "%" which are used in the examples indicate "parts by mass" and "% by mass", respectively, unless otherwise specified.

### Example 1: Preparation of Film Mirror for Reflecting Sunlight

### (Preparation of film mirror 1: Comparative example)

### (Preparation of polymer film substrate 1)

A biaxially oriented polyester film (polyethylene terephthalate film) having a thickness of 60 µm was used as a polymer film substrate 1.

### (Preparation of silver reflective layer coating liquid 1 containing silver complex compound)

In a 500 ml Schlenk flask equipped with a stirrer, 2-ethylhexylammonium 2-ethylcabamate (referred to as Compound 1 in Table 1) (65.0 g, 215 mmol) as an ammonium carbamate compound was dissolved in 2-propanpl (150.0 g), and then silver oxide (20.0 g, 86.2 mmol) as a silver compound was added to react at room temperature. The reaction mixture, which was initially black suspension, faded gradually into a transparent solution as the reaction proceeded with the formation of a silver complex compound. Two hours later, the solution turned completely colorless and transparent. To this solution, 2-hydroxy-2-methylpropylamine (2.5 g) as a stabilizer, and n-butanol (85.0 g) and amyl alcohol (50.0 g) as solvents were added followed by stirring. Then the mixture was filtered through a membrane filter having a pore size of 0.45 µm to give a silver reflective layer coating liquid 1 having a silver content of 4.87 mass% determined by thermogravimetric analysis (TGA).

### (Preparation of film mirror)

The silver reflective layer coating liquid 1 prepared above was applied onto the polymer film substrate 1 by gravure coating, and then the coating was calcined (fired) in an infrared oven at 150 °C for 10 minutes to form a silver reflective layer 1 having a thickness of 150 nm.

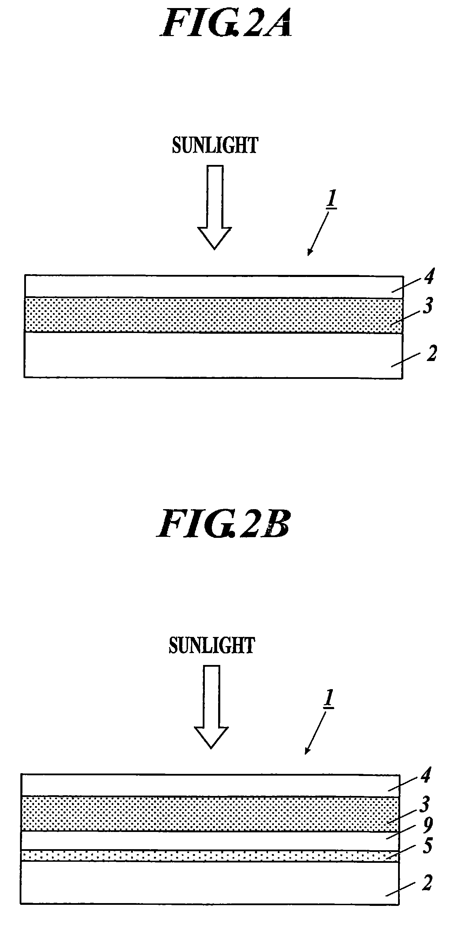

Then, a topcoat layer coating liquid was applied onto the silver reflective layer 1 by gravure coating to form a topcoat layer having a thickness of 0.1 µm and prepared a film mirror 1 having a layer structure illustrated in Fig. 2A and being provided with the topcoat layer at the solar incident side. The topcoat layer coating liquid was prepared by mixing a polyester resin (polyester SP-181 manufactured by Nippon Synthetic Chemical Industry Co., Ltd.) and 2,4-tolylene diisocyanate (TDI) in a ratio of 10:2 on the resin solids basis, and further adding a glycol dimercaptoacetate as a corrosion inhibitor in an amount such that the density of coating after coating became 0.3 g/m².

### (Preparation of film mirror 2: Comparative example)

A film mirror 2, which had a layer structure illustrated in Fig. 2B and a top coat layer provided at the solar incident side, was prepared in the same manner as the film mirror 1 except that a primer layer and a precoat layer described below were formed between a polymer film substrate 1 and a silver reflective layer 1.

### (Formation of primer layer)

A Henschel mixer was charged with solid state polyester having an acid value of 30 to 70 mg KOH/g (350.0 g) as a curable resin; solid state epoxy resin having an EEW of 600 to 1500 (350.0 g) as a bisphenol A type compound; Powdermate (10.0 g)(amide modified polyester manufactured by Troy Corporation) as a leveling agent; amide wax (8.0 g) (manufactured by Lubrizol Corporation) as an adhesion promoter; Tinuvin(TM) 405 (10.0 g) (manufactured by Ciba Japan K.K.) as a light stabilizer; and titanium dioxide (200.0 g) as a (white) colorant, which were homogeneously mixed therein. The mixture was extruded and then pulverized into particles having appropriate sizes. Then the powder was coated on the polymer film substrate 1 with a Corona electrostatic spray gun, and treated in an oven at 150°C for 30 minutes to form a primary layer.

### (Formation of precoat layer)

A curable silicone resin KR255 (manufactured by Shin-Etsu Chemical Co., Ltd.) was coated on the primer layer with a spray gun and then treated in an oven at 150°C for 3 hours to form a precoat layer.

### (Preparation of film mirror 3: Comparative example)

A film mirror 3 was prepared in the same manner as the film mirror 2 except that UV absorber TINUVIN(TM) 171 (manufactured by CIBA Japan K.K.) was added to the topcoat layer coating liquid used for formation of the topcoat layer in an amount such that the density of coating of the UV absorber was 0.05 g/m².

### (Preparation of film mirror 4: Inventive example)

A polymer film substrate 2 composed of a biaxially oriented thermoplastic poly(methyl methacrylate) resin film (weight average molecular weight: 100,000, number average molecular weight: 50,000; hereinafter referred to simply as "acrylic film") having a thickness of 60 µm was used.

The silver reflective layer coating liquid 1 prepared above was coated on the polymer film substrate 2 by gravure coating, and then the coating was calcined in an infrared oven at 100°C for 10 minutes to form the silver reflective layer having a thickness of 150 nm.

Then, a topcoat layer liquid containing a mixture of polyester resin (polyester SP-181 manufactured by Nippon Synthetic Chemical Co.) and 2,4-tolylene diisocyanate (TDI) in a ratio of 10:2 on the resin solids basis and glycol dimercaptoacetate as a corrosion inhibitor in an amount such that the density of coating was 0.3 g/m² was applied onto the silver reflective layer by gravure coating to form a topcoat layer having a thickness of 0.1 µm. Thus, the film mirror 4, which have a layer structure illustrated in Fig. 1A and the topcoat layer provided at the solar incident side, was prepared.

### (Preparation of film mirror 5: Comparative example)

A film mirror 5 was prepared in the same manner as the film mirror 4 except that a silver reflective layer having a thickness of 150 nm was formed by a known vacuum deposition process instead of a wet coating process using the silver reflective layer coating liquid 1.

### (Preparation of film mirror 6: Inventive example)

A film mirror 6 having a layer structure illustrated in Fig. 1B and provided with the polymer film substrate at the solar incident side was prepared in the same manner as the film mirror 4 except that a prime layer described below was formed between the polymer film substrate (acrylic film) 2 and silver reflective layer.

### (Formation of a primer layer)

A primer layer coating liquid was applied onto one side of the polymer film substrate 2 by gravure coating to form the primer layer having a thickness of 0.1 µm. The primer layer coating liquid was prepared by mixing a polyester resin, melamine resin, tolylene diisocyanate (TDI), and HMDI in a ratio of 20:1:1:2 on the resin solids basis and further adding a glycol dimercaptoacetate as a corrosion inhibitor in an amount such that the coating density after coating became 0.2 g/m²

### (Preparation of film mirror 7: Inventive example)

A film mirror 7 was prepared in the same manner as the film mirror 6 except that a polymer film substrate 3 (an acrylic film containing an UV absorber described below) was used instead of the polymer film substrate 2.

### (Preparation of polymer film substrate 3)

Tinuvin(TM) 928 (manufactured by Ciba Japan K.K.) (5 mass%) was incorporated as a UV absorber into a biaxially oriented poly (methyl methacrylate) resin film (weight average molecular weight: 100,000, a number average molecular weight: 50, 000) in the process of film-forming to prepare the polymer film substrate 3 having a thickness of 60 µm.

### (Preparation of film mirror 8: Inventive example)

A film mirror 8 was prepared in the same manner as the film mirror 6 except that a polymer film substrate 4 (an acrylic film containing an antioxidant described below) was used instead of the polymer film substrate 2.

### (Preparation of polymer film substrate 4)

Pentaerythrityl tetrakis(3-laurylthiopropionate) (5 mass%) was incorporated as a sulfur antioxidant into a biaxially oriented poly (methyl methacrylate) resin film (weight average molecular weight: 100,000, number average molecular weight: 50, 000) in the process of film-forming to prepare the polymer film substrate 4 having a thickness of 60 µm.

### (Preparation of film mirror 9: Inventive example)

A film mirror 9 was prepared in the same manner as the film mirror 6 except that a polymer film substrate 5 (an acrylic film containing a stabilizer below) was used instead of the polymer film substrate 2.

### (Preparation of polymer film substrate 5)

Tetrakis(2,2,6,6-tetramethyl-4-piperidyl)-1,2,3,4-tet rabutane caboxylate (5 mass% )as a hindered amine-stabilizer was incorporated into a biaxially oriented poly(methyl methacrylate) resin film (weight average molecular weight 100,000, a number average molecular weight 50,000) in the process of film-forming to prepare the polymer film substrate 5 having a thickness of 60 µm.

### (Preparation of film mirror 10: Inventive example)

A film mirror 10 was prepared in the same manner as the film mirror 7 except that a polymer film substrate 6 (a cycloolefin resin film of 60 µm thickness prepared by the process described in paragraphs [0476] to [0480] of Japanese Unexamined Patent Application Publication No. 2008-3359) was used instead of the polymer film substrate 3.

### (Preparation of film mirror 11: Inventive example)

A film mirror 11 was prepared in the same manner as the film mirror 7 except that a biaxially oriented polyester film (polyethylene terephthalate film of 60 µm thickness) is used as a polymer film substrate 7 instead of the polymer film substrate 3.

### (Preparation of film mirror 12: Inventive example)

A film mirror 12 was prepared in the same manner as the film mirror 7 except that morpholinium morpholinecarbamate (Compound 2) was used instead of 2-ethylhexylammonium 2-ethylcarbamate (Compound 1) as an ammonium carbamate compound used for preparing a silver reflective layer.

### (Preparation of film mirror 13: Inventive example)

A film mirror 13 was prepared in the same manner as the film mirror 7 except that dibutylammonium dibutyl carbonate (Compound 3) was used instead of 2-ethylhexylammonium 2-ethylcarbamate (Compound 1) as an ammonium carbamate compound used for forming a silver reflective layer.

Configurations of the film mirrors 1 to 13 prepared above are described in Table 1.

**[Table 1]**

| Film mirror No. | Configuration | Polymer film substrate | | Primer layer | Silver reflective layer | | | UV absober in protective coating layer | Remark |
|---|---|---|---|---|---|---|---|---|---|
| | | Material | Additive | | Process of formation | Material of formation | | | |
| | | | | | | Silver compound | Complex Compound | | |
| 1 | Fig. 2A | PET | - | Not present | Wet coating | Siver oxide | Compound 1 | Not present | Comparative |
| 2 | Fig. 2B | PET | - | Present | Wet coating | Siver oxide | Compound 1 | Not present | Comparative |
| 3 | Fig. 2B | PET | - | Present | Wet coating | Siver oxide | Compound 1 | Present | Comparative |
| 4 | Fig. 1A | Acrylic | - | Not present | Wet coating | Siver oxide | Compound 1 | Not present | Invention |
| 5 | Fig. 1A | Acrylic | - | Not present | Vacuum deposition | - | - | Not present | Comparative |
| 6 | Fig. 1B | Acrylic | - | Present | Wet coating | Siver oxide | Compound 1 | Not present | Invention |
| 7 | Fig. 1B | Acrylic | UV absorber | Present | Wet coating | Siver oxide | Compound 1 | Not present | Invention |
| 8 | Fig. 1B | Acrylic | Antioxidant | Present | Wet coating | Siver oxide | Compound 1 | Not present | Invention |
| 9 | Fig. 1B | Acrylic | Stabilizer | Present | Wet coating | Siver oxide | Compound 1 | Not present | Invention |
| 10 | Fig. 1B | COP | UV absorber | Present | Wet coating | Siver oxide | Compound 1 | Not present | Invention |
| 11 | Fig. 1B | PET | UV absorber | Present | Wet coating | Siver oxide | Compound 1 | Not present | Invention |
| 12 | Fig. 1B | Acrylic | UV absorber | Present | Wet coating | Siver oxide | Compound 2 | Not present | Invention |
| 13 | Fig. 1B | Acrylic | UV absorber | Present | Wet coating | Siver oxide | Compound 3 | Not present | Invention |

| | | | | | | | | | |
|---|---|---|---|---|---|---|---|---|---|
| PET: Polyethylene terephthalate film Acrylic: Poly (methyl methacrylate) resin film COP: Cycloolefin resin film | | | | | | | | | |

### (Evaluation of film mirror)

### (Measurement of initial spot diameter)

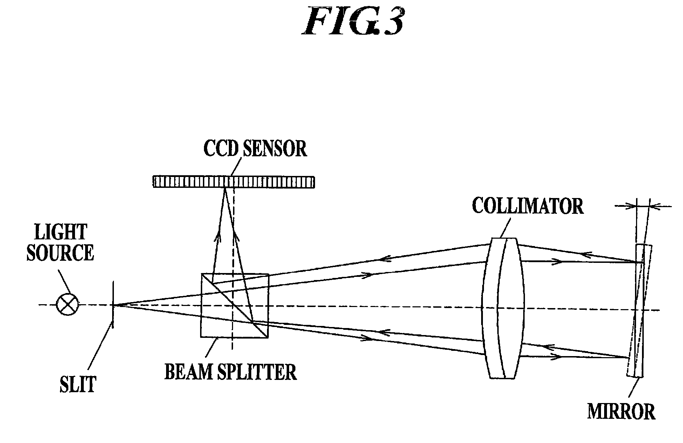

A reflected spot diameter of each of the film mirrors prepared above was measured with a compact working autocollimator WV-60 (manufactured by Nikon Engineering Co., Ltd.) having the internal configuration illustrated in Fig. 3. The effective observation area was set to be a circle with a diameter of 28 mm. If a film mirror surface has a specular surface and hence a high reflectance, a spot having the same diameter as that of the light flux incident on the film mirror appears on the monitor through a CCD sensor. An initial spot diameter closer to 28 mm indicates higher reflectance.

### (Initial 5-degree specular reflectance)

The 5-degree specular reflectance on the sunlight incident surface of each of the film mirrors prepared above was measured. The spectral reflectance at the incident angle of 5 degrees was measured relative to the reference sample with a U-4100 spectrophotometer (solid sample measurement system, manufactured by Hitachi High-Technologies Corporation). It was checked whether there were any parts of wavelength ranges where the reflectance dropped in the wavelength range of 250 nm to 2500 nm. The average reflectance in the visible light region (400 nm to 800 nm) was defined to be the 5-degree specular reflectance.

### (Evaluation of abrasion resistance)

Steel wool #0000 (manufactured by Nippon Steel Wool Co. , Ltd.) was reciprocated by 20 cycles on the sunlight incident surface of each of the film mirrors prepared above under a load of 1000 g/cm² with an abrasion tester (Tribostation Type 32, moving speed: 4000 mm/min; manufactured by Shinto Scientific Co., Ltd.). After 20 cycles of reciprocation, spot diameters were each measured in the same manner as described above. A smaller deviation from the initial spot diameter indicates higher abrasion resistance.

### (Evaluation of weather resistance)

Each of the film mirrors prepared above was left in an environment of 85 ° C, 85% RH for 30 days. After that the sunlight incident surface of the film mirror was irradiated with a xenon lamp (SX-75, manufactured by Suga Test Instruments Co., Ltd.; irradiation intensity: 180 W/m² for 168 hours). After irradiation with the Xenon lamp, 5-degree specular reflectance was measured in the same manner as described above. A smaller deviation from the initial 5-degree specular reflectance indicates higher weather resistance.

### (Evaluation of adherence)

Each of the film mirrors was subjected to a cross cut test in accordance with JIS K 5400. More specifically, eleven notches were formed at intervals of 1 mm vertically and horizontally on the side of the reflective layer to form a grid of 100 squares (1 mm x 1 mm). A cellophane adhesive tape was then applied to the surface of the grid and stripped off abruptly at an angle of 90 degrees. The number of the squares remaining unpeeled was counted. The state of adhesion between the polymer film substrate and the reflective layer of each film mirror was ranked in accordance with the following criteria.

A: No peeled squares were observed.
B: The number of peeled squares was 1 or more and 5 or less.
C: The number of peeled squares was 6 or more and 10 or less.
D: The number of peeled squares was 11 or more and 20 or less.
E: The number of peeled squares was 21 or more.
Table 2 shows the results.

**[Table 2]**

| Film mirror No. | Evaluation of initial performance | | Abrasion resistance Spot diameter (mm) | Weatherability 5-degree specular reflectance (%) | Adhesion | Remark |
|---|---|---|---|---|---|---|
| | Spot diameter (mm) | 5-degeree specular reflectance (%) | | | | |
| 1 | 33 | 76 | 60 | 35 | C | Comparative |
| 2 | 34 | 72 | 60 | 34 | B | Comparative |
| 3 | 35 | 74 | 45 | 71 | B | Comparative |
| 4 | 28 | 93 | 32 | 85 | B | Invention |
| 5 | 29 | 91 | 37 | 83 | C | Comparative |
| 6 | 29 | 93 | 32 | 86 | A | Invention |
| 7 | 30 | 93 | 33 | 91 | A | Invention |
| 8 | 29 | 93 | 32 | 89 | A | Invention |
| 9 | 29 | 93 | 32 | 90 | A | Invention |
| 10 | 30 | 91 | 33 | 88 | A | Invention |
| 11 | 32 | 90 | 35 | 86 | B | Invention |
| 12 | 30 | 91 | 34 | 88 | A | Invention |
| 13 | 30 | 92 | 33 | 91 | A | Invention |

As can be seen from the results in Table 2, the film mirrors of the present invention have a higher regular reflectance as well as superior properties of abrasion resistance, weather resistance, and adherence compared to comparative examples.

### Example 2: Preparation of Reflective Device for Solar Thermal Power Generation

An acrylic adhesive S-dine(TM) #7851 (manufactured by Sekisui Chemical Co., Ltd.) was applied onto the surface opposite to the sunlight incident surface of each film mirror in an amount such that the thickness of coating became 5 µm to form an adhesive layer. The adhesive layer was then bonded to an aluminum support of 1 mm thickness to prepare a reflective device for solar thermal power generation.

### (Evaluation of reflective device for solar thermal power generation)

Regular reflectance, abrasion resistance, weather resistance and durability properties in a variety of temperature and humidity environments were evaluated in the same manner as in Example 1. The results show that the reflective devices for solar thermal power generation of the present invention have superior properties compared with the comparative examples.

### Industrial Application

The present invention, which is constructed in the manner described above, can be used as a film mirror for reflecting sunlight and a reflective device for solar thermal power generation.

### Explanation of symbols

| | |
|---|---|
| 1 | film mirror for reflecting sunlight |
| 2 | polymer film substrate |
| 3 | reflective layer |
| 4 | protective coating layer |
| 5 | primer layer |
| 6 | reflective device for solar thermal power |
| 7 | adhesive layer |
| 8 | holding member |
| 9 | precoat layer |

## Claims

1. A film mirror for reflecting sunlight, comprising, in sequence from the incident side of sunlight:
a polymer film substrate,
a reflective layer comprising silver coating, and
a protective coating layer, wherein;
the reflective layer is formed by coating and calcining a coating liquid containing a silver complex compound.

2. The film mirror for reflecting sunlight according to Claim 1, further comprising a primer layer between the polymer film substrate and the reflective layer.

3. The film mirror for reflecting sunlight according to Claim 1 or 2, wherein the silver complex compound is prepared by a reaction of a silver compound represented by Formula (1) with at least one compound selected from the compounds represented by Formulae (2) to (4):
Formula (1) AgₙX
wherein X represents at least one substituent selected from the group consisting of an oxygen atom, sulfur atom, halogen atom, cyano group, cyanate group, carbonate group, nitrate group, nitrite group, sulfate group, phosphate group, thiocyanate group, chlorate group, perchlorate group, tetrafluoroborate group, acetylacetonate group, carboxylate group and derivatives thereof, and n represents an integer of 1 to 4, and 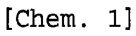 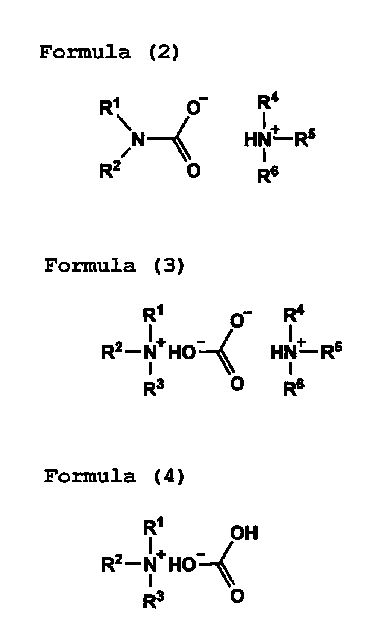 wherein R¹ to R⁶ each independently represent at least one substituent selected from the group consisting of a hydrogen atom, aliphatic alkyl group having 1 to 30 carbon atoms, alicyclic alkyl group having 1 to 30 carbon atoms, aryl group, aralkyl group, functional-group-substituted alkyl group, functional-group-substituted aryl group, heterocyclic group, polymer group, and derivatives thereof.

4. The film mirror for reflecting sunlight according to any one of Claims 1 to 3, wherein the polymer film substrate has a thickness of 9 µm or more and 175 µm or less.

5. The film mirror for reflecting sunlight according to any one of Claims 1 to 4, wherein the polymer film substrate comprises an acrylic resin film or a polyolefin resin film.

6. The film mirror for reflecting sunlight according to any one of Claims 1 to 5, wherein the polymer film substrate comprises a UV absorber.

7. The film mirror for reflecting sunlight according to any one of Claims 1 to 6, wherein the polymer film substrate comprises an antioxidant or stabilizer.

8. A reflective device for solar thermal power generation, comprising the film mirror for reflecting sunlight according to any one of Claims 1 to 7 being provided on a holding member through an adhesive layer.
